# EUROPÄISCHE PATENTSCHRIFT

(11) **EP 3 972 741 B1**
(45) Veröffentlichungstag und Bekanntmachung des Hinweises auf die Patenterteilung: **02.07.2025**
(21) Anmeldenummer: 20726013.4
(22) Anmeldetag: 08.05.2020
(51) Int. Cl.: B05B 12/00, B25J 9/16, G05B 17/02

(54) **SCHICHTDICKENOPTIMIERUNGS- UND PROGRAMMIERVERFAHREN FÜR EINE BESCHICHTUNGSANLAGE UND ENTSPRECHENDE BESCHICHTUNGSANLAGE**
COATING THICKNESS OPTIMIZATION AND PROGRAMMING METHOD FOR A COATING SYSTEM AND CORRESPONDING COATING SYSTEM
PROCÉDÉ POUR OPTIMISER ET PROGRAMMER UNE ÉPAISSEUR DE COUCHE POUR UNE INSTALLATION DE REVÊTEMENT ET INSTALLATION DE REVÊTEMENT CORRESPONDANTE

(30) Priorität: 20.05.2019 DE 102019113341
(43) Veröffentlichungstag der Anmeldung: 30.03.2022
(73) Patentinhaber: Dürr Systems AG, 74321 Bietigheim-Bissingen (DE)
(72) Erfinder: NOLTE, Hans-Jürgen, 74354 Besigheim (DE); HERRE, Frank, 71739 Oberriexingen (DE); HECKELER, Christoph, 71272 Renningen (DE)
(74) Vertreter: v. Bezold & Partner Patentanwälte - PartG mbB
(86) Internationale Anmeldenummer: PCT/EP2020/062874
(87) Internationale Veröffentlichungsnummer: WO 2020/234008

(56) Entgegenhaltungen:
- EP-A1- 0 867 233
- DE-A1- 10 225 276
- ARIKAN S.BALKAN T.: "Modeling of paint flow rate flux for elliptical paints sprays by using experimental paint thickness distributions", INDUSTRIAL ROBOT, vol. 33, no. 1, 2006, XP002799327

## Beschreibung

Die Erfindung betrifft ein Verfahren zur Parametrierung und Programmierung eines programmgesteuerten Beschichtungsroboters zur Beschichtung von Bauteilen, insbesondere für einen Lackierroboter zur Lackierung von Kraftfahrzeugkarosseriebauteilen. Weiterhin betrifft die Erfindung eine entsprechend arbeitende Beschichtungsanlage.

In modernen Lackieranlagen zur Lackierung von Kraftfahrzeugkarosseriebauteilen werden als Applikator üblicherweise Rotationszerstäuber eingesetzt, die von einem mehrachsigen Lackierroboter mit einer seriellen Roboterkinematik entlang vorgegebener Roboterbahnen über die Oberflächen der zu lackierenden Kraftfahrzeugkarosseriebauteile geführt werden. Dabei wird der Rotationszerstäuber mit bestimmten Applikationsparametern (z.B. Lackmenge, Drehzahl, Lenkluft, Hochspannung der elektrostatischen Beschichtungsmittelaufladung etc.) betrieben.

Die Herausforderung hierbei ist die Programmierung der Applikationsparameter und der Roboterbahnen für eine bestimmte Kraftfahrzeugkarosserie mit einer vorgegebenen Form.

Ein herkömmlicher Ansatz zur Programmierung der Applikationsparameter und der Roboterbahnen besteht in dem sogenannten "Teachen". Dabei legt der Programmierer die Roboterbahn entlang der Bauteiloberfläche fest, indem bestimmte Bahnpunkte der Roboterbahn programmiert werden, die dann im Lackierbetrieb automatisch abgefahren werden. Darüber hinaus legt der Programmierer hierbei entsprechend seiner Erfahrung die Applikationsparameter fest, die von dem Rotationszerstäuber beim Abfahren der vorgegebenen Roboterbahn eingehalten werden. In einem Testbetrieb erfolgt dann eine Lackierung mit der vorgegebenen Roboterbahn und den vorgegebenen Applikationsparametern, um dann das Lackierergebnis zu prüfen. In Abhängigkeit von der Qualität des erreichten Lackierergebnisses können dann die Roboterbahn und die Applikationsparameter angepasst werden, um das Lackierergebnis entsprechend zu verbessern. Auf diese Weise kann man in wenigen Iterationsschritten zu einem akzeptablen Lackierergebnis gelangen.

Nachteilig an diesem bekannten Ansatz zum Programmieren der Roboterbahnen und der Applikationsparameter ist zunächst die Tatsache, dass die Erfahrung des Programmierers wichtig ist für die Erreichung eines guten Lackierergebnisses. Darüber hinaus sind hierbei üblicherweise mehrere Iterationsschritte (Optimierungsschleifen) erforderlich, die jeweils mit einem entsprechenden Materialverbrauch verbunden sind.

Ein anderer Ansatz zur Programmierung der Roboterbahnen und der Applikationsparameter besteht in einer vollständigen Simulation des Lackierergebnisses in einem entsprechenden Computermodell.

Nachteilig an diesem Ansatz zum Programmieren der Roboterbahnen und der Applikationsparameter ist zunächst die Tatsache, dass eine enorme Rechenleistung erforderlich ist, um aussagekräftige Ergebnisse hinsichtlich des Lackierergebnisses zu erzielen. Darüber hinaus ist die physikalische Modellierung des kompletten Lackiervorganges äußerst schwierig, so dass die Aussagekraft einer solchen modellgestützten Ermittlung des Lackierergebnisses noch nicht vollständig befriedigend ist.

Zum technischen Hintergrund der Erfindung ist auch hinzuweisen auf die folgenden Veröffentlichungen:
- US 5 521477 A,
- DE 101 50 826 A1,
- EP 0 867 233 A1,
- DE 102 25 276 A1,
- Shengrui, Y., Ligang, C.: "Modeling and Prediction of Paint Film Deposition Rate for Robotic Spray Painting", Proceedings of the 2011 IEEE International Conference on Mechatronics and Automation 2011.

Schließlich ist ein Verfahren gemäß dem Oberbegriff von Anspruch 1 bekannt aus Arikan S., Balkan T.: "Modeling of paint flow rate flux for elliptical paints sprays by using experimental paint thickness distributions", Industrial Robot, Vol. 33, 2006 No. 1, ISSN 0143-991X. Dieses bekannte Verfahren ist jedoch noch nicht vollständig befriedigend.

Der Erfindung liegt deshalb die Aufgabe zugrunde, einen verbesserten Ansatz zum Parametrieren, Optimieren und Programmieren der Roboterbahnen und der Applikationsparameter zu schaffen.

Diese Aufgabe wird durch ein erfindungsgemäßes Verfahren bzw. eine entsprechende Beschichtungsanlage gemäß den unabhängigen Ansprüchen gelöst.

Das erfindungsgemäße Verfahren sieht zunächst vor, dass eine Roboterbahn vorgegeben wird, wie es grundsätzlich aus dem Stand der Technik bekannt ist. Beispielsweise kann die Roboterbahn durch eine Vielzahl von Bahnpunkten definiert werden, die dann nacheinander von dem Farbauftreffpunkt des Applikators (z.B. Rotationszerstäuber) abgefahren werden. Dabei kann die Roboterbahn nicht nur die Position der einzelnen Bahnpunkte in kartesischen Raumkoordinaten wiedergeben, sondern auch die gewünschte räumliche Ausrichtung der Sprühachse des verwendeten Applikators (z.B. Rotationszerstäuber).

Darüber hinaus sieht das erfindungsgemäße Verfahren vor, dass Applikationsparameter vorgegeben werden, die von dem Applikator und dem Beschichtungsroboter im realen Beschichtungsbetrieb bei der Bewegung entlang der Roboterbahn eingehalten werden sollen. Der im Rahmen der Erfindung verwendete Begriff eines Applikationsparameters umfasst vorzugsweise die Betriebsgrößen des verwendeten Applikators, wie beispielsweise Zerstäuberdrehzahl, Lenkluftstrom/Lenkluftdruck, Hochspannung einer elektrostatischen Beschichtungsmittelaufladung und/oder Lackvolumenstrom. Der im Rahmen der Erfindung verwendete Begriff von Applikationsparametern ist jedoch nicht auf die vorstehend genannten Beispiele von Betriebsgrößen des Applikators beschränkt. Darüber hinaus umfasst der im Rahmen der Erfindung verwendete Begriff von Applikationsparametern vorzugsweise auch Betriebsgrößen des Beschichtungsroboters, wie beispielsweise die Lackiergeschwindigkeit, mit der der Beschichtungsroboter den Applikator über die Bauteiloberfläche bewegt.

Im Rahmen des erfindungsgemäßen Programmierverfahrens wird dann virtuell das Lackierergebnis ermittelt, das bei einer Lackierung entlang der vorgegebenen Roboterbahn mit den vorgegebenen Applikationsparametern erzielt wird. Diese virtuelle Ermittlung des Lackierergebnisses erfolgt jedoch im Rahmen der Erfindung nicht ausschließlich modellgestützt, sondern unter Berücksichtigung realer Spritzbilddaten.

So werden im Vorfeld Spritzversuche mit dem Applikator durchgeführt, wobei jeweils für bestimmte Applikationsparameter und bestimmte Roboterbahnen das Lackierergebnis real gemessen wird. Beispielsweise können hierzu Versuchsbleche beschichtet werden, wobei dann der Schichtdickenverlauf auf dem Versuchsblech gemessen wird. Die auf diese Weise ermittelten Spritzbilddaten werden dann in einer Zuordnung zu den jeweiligen Applikationsparametern und der jeweiligen Roboterbahn in einer Datenbank gespeichert.

Im Rahmen des erfindungsgemäßen Programmierverfahrens werden die Spritzbilddaten ermittelt, die zu den vorgegebenen Applikationsparametern und der vorgegebenen Roboterbahn gehören. Die virtuelle Ermittlung des Lackierergebnisses erfolgt dann in Abhängigkeit von diesen Spritzbilddaten, die zuvor real gemessen wurden. Dabei erfolgt eine Extrapolation, beispielsweise von dem Schichtdickenverlauf auf einem ebenen Versuchsblech auf den entsprechenden Schichtdickenverlauf auf einer gewölbten Bauteiloberfläche. Das erfindungsgemäße Programmierverfahren ermittelt das Lackierergebnis also quasi in hybrider Form, indem sowohl reale Spritzbilddaten berücksichtigt werden als auch ein Extrapolationsmodell zur Umrechnung der realen Spritzbilddaten auf die reale Kraftfahrzeugkarosserie.

Die Roboterbahn und die Applikationsparameter werden dann im Rahmen des erfindungsgemäßen Programmierverfahrens optimiert, was in mehreren Iterationsschleifen erfolgen kann. Falls das virtuell ermittelte Lackierergebnis nicht befriedigend ist, so können die Applikationsparameter und die Roboterbahn angepasst werden, um dann das Lackierergebnis virtuell für die angepassten Applikationsparameter und/oder die angepasste Roboterbahn zu ermitteln. Auf diese Weise kann in wenigen Iterationsschleifen ein akzeptables Lackierergebnis erreicht werden, wobei die zugehörigen Applikationsparameter und die zugehörige Roboterbahn dann für den späteren Lackierbetrieb übernommen werden. Vorteilhaft an diesen erfindungsgemäßen Programmierverfahren ist die Tatsache, dass die Iterationsschleifen für die Ermittlung der akzeptablen Applikationsparameter und der akzeptablen Roboterbahn nicht zu einem entsprechenden Materialverbrauch führen, da das Lackierergebnis jeweils virtuell ermittelt wird.

Die Variation der Applikationsparameter bzw. der Bahnverläufe (Roboterbahn) in gegebenen Grenzen zur Optimierung der Schichtdickengleichmäßigkeit erfolgt in erster Linie automatisch basierend auf einem Computeralgorithmus. Dies ist vorzugsweise Aufgabe einer Optimierungseinheit, welche die in der virtuellen Ermittlung des Lackierergebnisses erreichte Schichtdickengleichmäßigkeit mit einer zulässigen Schichtdickenschwankung automatisch vergleicht und ggf. Iterationsschleifen mit geänderten Applikationsparametern und/oder Bahnverläufen (Roboterbahnen) anstößt. Die gegebenen Grenzen ergeben sich aus den erfahrungsgemäß für die industrielle Anwendung günstigen Prozessfenstern der Applikationsparameter bzw. bewährter Konzepte der Roboterbahnverläufe. Ergänzend oder alternativ zu diesem automatischen Optimierungsprozess können die Beurteilung der Schichtdickengleichmäßigkeit und die Variation der Applikationsparameter bzw. Bahnverläufe auch "manuell" durch den Benutzer erfolgen.

Es wurde bereits vorstehend kurz erwähnt, dass die Spritzbilddaten beispielsweise durch Versuche ermittelt werden können, bei denen Versuchsbleche mit verschiedenen Sätzen von Applikationsparametern beschichtet werden. Das erfindungsgemäße Programmierverfahren umfasst deshalb auch die Durchführung von realen Applikationsversuchen mit verschiedenen Applikationsparametern und/oder verschiedenen Roboterbahnen, insbesondere durch Beschichtung von Versuchsblechen mit den verschiedenen Applikationsparametern. Dabei wird dann das Spritzbild bei den realen Applikationsversuchen gemessen und es werden entsprechende Spritzbilddaten ermittelt. Die auf diese Weise ermittelten Spritzbilddaten werden dann für die verschiedenen Applikationsparameter und Roboterbahnen in der Datenbank gespeichert. Hierbei ist es wichtig, dass die Speicherung der Spritzbilddaten in der Datenbank in einer festen Zuordnung zu den zugrunde liegenden Applikationsparametern und Roboterbahnen erfolgt, damit dann später in Abhängigkeit von den Applikationsparametern und der Roboterbahn die zugehörigen Spritzbilddaten aus der Datenbank ausgelesen werden können.

In der Praxis ist es schwierig, dass für sämtliche Kombinationen von Applikationsparametern und Roboterbahnen Spritzbilddaten real gemessen und gespeichert werden. Die Erfindung sieht deshalb vor, dass die Datenbank ein Kennfeld enthält, in dem die real gemessenen Spritzbilddaten lediglich einzelne Stützstellen bilden. Die restlichen Kennfeldpunkte werden dann aus diesen Stützstellen interpoliert.

Weiterhin ist zu erwähnen, dass die Lackierung einer Kraftfahrzeugkarosserie üblicherweise mit unterschiedlichen sogenannten Brushs erfolgt. Der im Rahmen der Erfindung verwendete Begriff eines Brushs definiert vorzugsweise den kompletten Satz der Applikationsparameter und die Roboterbahn. So erfolgt eine großflächige Lackierung üblicherweise mit einem sogenannten Flächen-Brush, der sich durch eine breite Form bzw. ein breites Schichtdickenprofil auszeichnet. Die Lackierung von Rändern oder Details erfolgt dagegen üblicherweise mit einem sogenannten Kanten-Brush, der sich durch eine enge Form bzw. ein enges Schichtdickenprofil auszeichnet. Die Datenbank mit den Spritzbilddaten sollte deshalb vorzugsweise Spritzbilddaten sowohl für den Flächen-Brush als auch für den Kanten-Brush enthalten. Im Rahmen des erfindungsgemäßen Programmierverfahrens erfolgt dann vorzugsweise eine Optimierung des Flächen-Brushs in der vorstehend allgemein beschriebenen Weise. Anschließend erfolgt dann die separate Optimierung des Kanten-Brushs in im Wesentlichen der gleichen Weise.

Weiterhin ist zu erwähnen, dass der Kanten-Brush beispielsweise zur Lackierung von Kotflügeln, A-Säulen, B-Säulen, C-Säulen, Tornadolinien oder von Schwellerbereichen eingesetzt werden kann, um nur einige Beispiele zu nennen.

Die optimierten Flächen- und Kantenbrushes können z.B. an Modulstößen (Übergangsbereiche zwischen einzelnen Lackiermodulen, z.B. zwischen Kotflügel und Motorhaube) zu nicht zufriedenstellenden Lackierergebnissen führen (Hot-Spots). Im Rahmen der Erfindung ist deshalb auch Optimierung der Schichtdickengleichmäßigkeit an Hot-Spots möglich durch lokale Variation der Roboterbahnen und der betroffenen Brushs, ggf. durch Anpassung der Ein-/Ausschaltpunkte des Lackflusses.

Ferner ist zu erwähnen, dass im Rahmen der Erfindung vorzugsweise nicht nur die Betriebsgrößen des Applikators (z.B. Rotationszerstäuber) optimiert werden, sondern vorzugsweise auch die Roboterbahn selbst.

Hinsichtlich der Spritzbilddaten bestehen im Rahmen der Erfindung verschiedene Möglichkeiten. Beispielsweise können die Spritzbilddaten für die einzelnen Spritzbilder jeweils mindestens einen Spritzbild-Kennwert umfassen, der das Spritzbild charakterisiert. Beispielsweise kann es sich hierbei um den an sich bekannten SB[50]-Wert handeln. Der SB[50]-Wert ist hierbei die Breite des Schichtdickenverlaufs, innerhalb derer die Schichtdicke auf der Bauteiloberfläche mindestens 50% der maximalen Schichtdicke SDmax beträgt. Es besteht jedoch alternativ oder zusätzlich auch die Möglichkeit, dass zumindest einer der Spritzbild-Kennwerte ein SDmax-Wert ist, der die maximale Schichtdicke wiedergibt.

Weiterhin ist zu erwähnen, dass der reale Schichtdickenverlauf durch mathematische Kurven (z.B. Gauß-Kurven) wiedergegeben werden kann.

Darüber hinaus besteht im Rahmen der Erfindung die Möglichkeit, dass das Lackierergebnis grafisch dargestellt wird, beispielsweise mit dem resultierenden Schichtdickenverlauf. Der Programmierer kann dann das virtuell ermittelte Lackierergebnis anhand der Anzeige unmittelbar beurteilen und entscheiden, ob das Lackierergebnis akzeptabel ist.

Neben dem vorstehend beschriebenen erfindungsgemäßen Programmierverfahren umfasst die Erfindung auch eine entsprechende Beschichtungsanlage, die zur Ausführung des erfindungsgemäßen Programmierverfahrens geeignet ist.

So umfasst die erfindungsgemäße Beschichtungsanlage üblicherweise einen Beschichtungsroboter und einen Applikator (z.B. Rotationszerstäuber), der von dem Beschichtungsroboter geführt wird und im Betrieb das Beschichtungsmittel auf das Bauteil (z.B. Kraftfahrzeugkarosserie) appliziert.

Die erfindungsgemäße Beschichtungsanlage zeichnet sich durch eine Datenbank aus, die für verschiedene Applikationsparameter und verschiedene Roboterbahnen Spritzbilddaten enthält, die ein reales Spritzbild wiedergeben, das der Applikator bei einem realen Beschichtungsbetrieb mit den Applikationsparametern und/oder auf der Roboterbahn erzeugt. Hierbei ist zu erwähnen, dass die Datenbank zu Beginn üblicherweise nicht vollständig mit den erforderlichen Spritzbilddaten gefüllt ist. Die Spritzbilddaten können dann im Laufe des Betriebs nachträglich ermittelt und in die Datenbank eingespeist werden.

Darüber hinaus umfasst die erfindungsgemäße Beschichtungsanlage eine Recheneinheit, die aus vorgegebenen Applikationsparametern und vorgegebenen Roboterbahnen das Lackierergebnis virtuell berechnet und dabei die gespeicherten Spritzbilddaten berücksichtigt.

Ferner umfasst die erfindungsgemäße Beschichtungsanlage eine Optimierungseinheit, welche die Applikationsparameter und/oder die Roboterbahn optimiert, was beispielsweise in mehreren Iterationsschleifen geschehen kann. Dabei gibt die Optimierungseinheit bestimmte Applikationsparameter und/oder eine bestimmte Roboterbahn vor und beurteilt dann das virtuell ermittelte Lackierergebnis. Falls das virtuell ermittelte Lackierergebnis akzeptabel ist, so können die Applikationsparameter und die Roboterbahn für den späteren realen Beschichtungsbetrieb übernommen werden. Andernfalls variiert die Optimierungseinheit die Applikationsparameter und die Roboterbahn, bis das virtuell ermittelte Lackierergebnis akzeptabel ist.

Die erfindungsgemäße Beschichtungsanlage weist vorzugsweise auch eine Anzeigeeinheit (z.B. Bildschirm) auf, um das Lackierergebnis grafisch darstellen zu können.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: ein Flussdiagramm zur Verdeutlichung des erfindungsgemäßen Programmierverfahrens,
- Figur 2: eine schematische Darstellung einer erfindungsgemäßen Lackieranlage,
- Figur 3: einen Schichtdickenverlauf, der real gemessen wurde,
- Figur 4: einen Schichtdickenverlauf, der real gemessen wurde mit einer mathematischen Annäherung,
- Figur 5: ein Beispiel für ein Kennfeld mit gespeicherten Spritzbilddaten, sowie
- Figur 6: ein Flussdiagramm zur Verdeutlichung einer Weiterbildung des erfindungsgemäßen Programmierverfahrens.

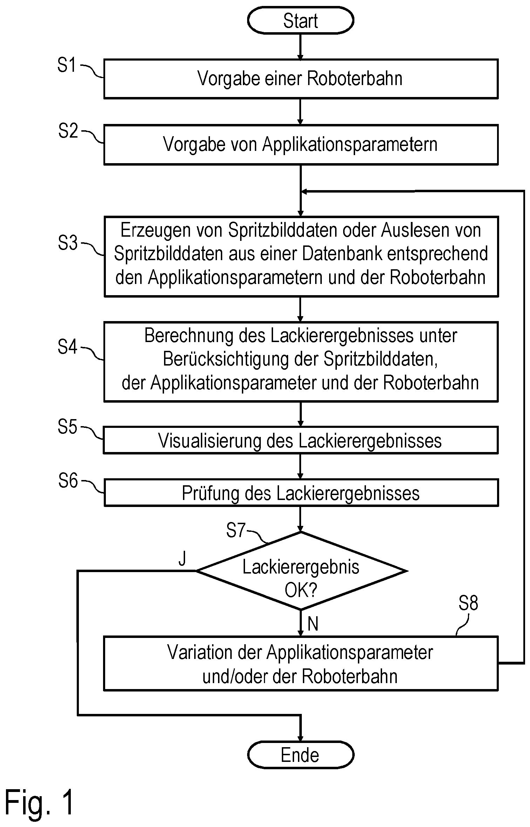

Im Folgenden wird nun das Flussdiagramm gemäß Figur 1 beschrieben, welches das erfindungsgemäße Programmierverfahren in schematischer Form verdeutlicht.

In einem ersten Schritt S1 wird zunächst eine Roboterbahn vorgegeben. Hierzu können Bahnpunkte definiert werden, die von dem Farbauftreffpunkt des verwendeten Applikators (z.B. Rotationszerstäuber) nacheinander abgefahren werden sollen. Die einzelnen Bahnpunkte können beispielsweise durch kartesische Raumkoordinaten (X, Y, Z) definiert werden. Darüber hinaus wird in den einzelnen Bahnpunkten vorzugsweise auch die gewünschte Ausrichtung der Sprühachse des verwendeten Applikators vorgegeben, wozu beispielsweise ein Vektor mit drei Komponenten (XR, YR, ZR) definiert werden kann.

In einem weiteren Schritt S2 wird dann der komplette Satz von Applikationsparametern definiert, mit denen der Applikator in dem eigentlichen Lackierbetrieb arbeiten soll. Hierzu zählen beispielsweise die Zerstäuberdrehzahl, der Lenkluftstrom, der Lackstrom, die Hochspannung der elektrostatischen Beschichtungsmittelaufladung und die Lackiergeschwindigkeit, mit der der Lackierroboter den Applikator über die Bauteiloberfläche bewegt.

In einem Schritt S3 werden dann Spritzbilddaten aus einer Datenbank ausgelesen, die zu der vorgegebenen Roboterbahn und den vorgegebenen Applikationsparametern passen und zuvor ermittelt wurden. Alternativ können die Spritzbilddaten auch erst erzeugt werden, sofern sie noch nicht gespeichert wurden.

In einem Schritt S4 erfolgt dann eine virtuelle Berechnung des Lackierergebnisses für die vorgegebene Roboterbahn und die vorgegebenen Applikationsparameter, wobei die Spritzbilddaten berücksichtigt werden, die aus der Datenbank ausgelesen wurden. Hierbei erfolgt beispielsweise eine Umrechnung bzw. Extrapolation der zuvor auf einem ebenen Versuchsblech gemessenen Spritzbilddaten auf das reale Lackierergebnis auf einer gewölbten Bauteiloberfläche.

In einem Schritt S5 kann das Lackierergebnis dann visualisiert werden.

In einem Schritt S6 wird dann geprüft, ob das das Lackierergebnis akzeptabel ist. Eine Möglichkeit hierzu besteht darin, dass der Programmierer selbst anhand der Visualisierung in Schritt S5 prüft, ob das Lackierergebnis akzeptabel ist. Eine bevorzugte andere Möglichkeit besteht jedoch darin, dass mittels eines Computeralgorithmus automatisch geprüft wird, ob das Lackierergebnis akzeptabel ist. Falls dies der Fall ist, so ist das Programmierverfahren in einem Schritt S7 beendet und die vorgegebene Roboterbahn und die vorgegebenen Applikationsparameter werden für die spätere **Lackierung** übernommen.

Andernfalls besteht noch Optimierungsbedarf, so dass dann in einem Schritt S8 die Applikationsparameter und/oder die Roboterbahn verändert werden, wobei die Schritte S3-S7 dann in einer Iterationsschleife wiederholt werden, bis ein akzeptables Lackierergebnis vorliegt. Diese Wiederholung in einer Iterationsschleife kann automatisch oder benutzergesteuert erfolgen.

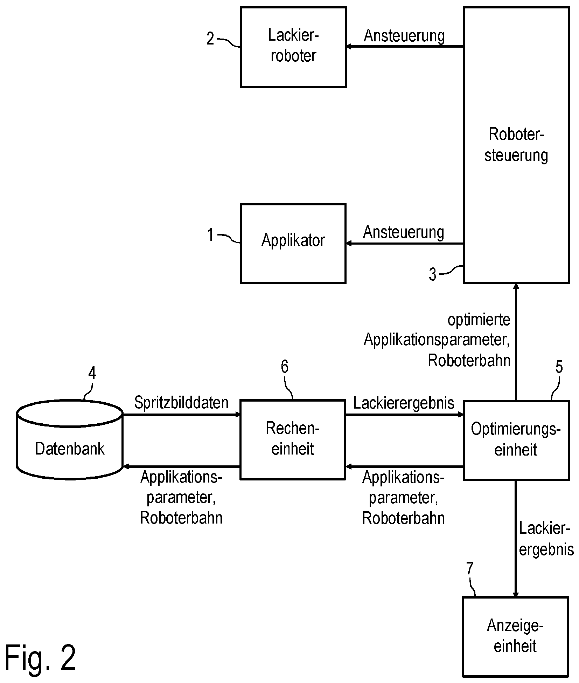

Figur 2 zeigt eine schematische, vereinfachte Darstellung einer erfindungsgemäßen Lackieranlage zur Lackierung von Kraftfahrzeugkarosseriebauteilen. Die Lackieranlage weist zunächst einen Applikator 1 auf, wobei es sich beispielsweise um einen Rotationszerstäuber handeln kann.

Der Applikator 1 wird im Betrieb von einem mehrachsigen Lackierroboter 2 mit einer seriellen Roboterkinematik über die Bauteiloberfläche bewegt.

Der Applikator 1 und der Lackierroboter 2 werden hierbei von einer Robotersteuerung 3 angesteuert, wobei die Robotersteuerung 3 den Lackierroboter 2 so ansteuert, dass der Applikator 1 mit seinem Farbauftreffpunkt eine vorgegebene Roboterbahn abfährt. Dabei steuert die Robotersteuerung 3 den Applikator 1 mit bestimmten Applikationsparametern (z.B. Zerstäuberdrehzahl, Lackstrom, etc.) an.

Hierbei ist zu erwähnen, dass die Robotersteuerung 3 auf mehrere Steuereinheiten verteilt sein kann.

Die erfindungsgemäße Lackieranlage weist zusätzlich eine Datenbank 4 auf, in der Spritzbilddaten für eine Vielzahl von unterschiedlichen Applikationsparametern und Roboterbahnen gespeichert sind. Diese Spritzbilddaten wurden zuvor in Spritzversuchen gemessen, wobei die Applikationsparameter und die Roboterbahn entsprechend variiert wurden.

Darüber hinaus weist die erfindungsgemäße Lackieranlage eine Optimierungseinheit 5 auf, die als Ausgangspunkt für die Optimierung zunächst einen Satz von Applikationsparametern und eine bestimmte Roboterbahn vorgibt und diese an eine Recheneinheit 6 weiter leitet. Die Recheneinheit 6 liest dann aus der Datenbank 4 in Abhängigkeit von den vorgegebenen Applikationsparametern und der vorgegebenen Roboterbahn die zugehörigen Spritzbilddaten aus. Die Recheneinheit 6 berechnet dann aus den Spritzbilddaten das Lackierergebnis auf der Bauteiloberfläche und meldet das Lackierergebnis an die Optimierungseinheit 5 zurück. Die Optimierungseinheit 5 stellt das Lackierergebnis dann auf einer Anzeigeeinheit 7 grafisch dar. Darüber hinaus kann die Optimierungseinheit 5 die Applikationsparameter und die Roboterbahn in einer Iterationsschleife variieren und optimieren, wobei jeweils das Lackierergebnis virtuell ermittelt und bewertet wird. Die Optimierung erfolgt also vorzugsweise automatisch durch die Optimierungseinheit 5.

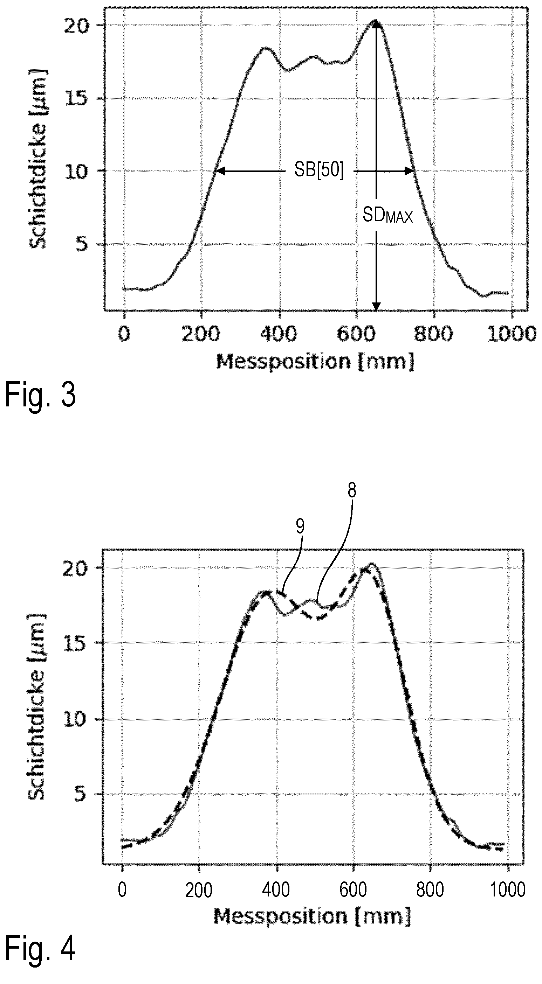

Figur 3 zeigt einen Schichtdickenverlauf, der von einem Rotationszerstäuber auf der Bauteiloberfläche erzeugt wird, wobei der Schichtdickenverlauf auf einer realen Messung beruht. Im Rahmen des erfindungsgemäßen Programmierverfahrens können dann aus dem realen Schichtdickenverlauf Spritzbild-Kennwerte berechnet werden, wie beispielsweise der SB[50]-Wert oder der Maximalwert SDₘₐₓ. Der SB[50]-Wert kennzeichnet hierbei die Breite des Schichtdickenverlaufs, innerhalb derer die Schichtdicke mindestens 50% der maximalen Schichtdicke SDₘₐₓ beträgt.

Figur 4 zeigt einen entsprechenden Schichtdickenverlauf und zwar zum einen einen real gemessenen Schichtdickenverlauf 8 und zum anderen einen mathematisch angenäherten Schichtdickenverlauf 9. Beispielsweise kann der real gemessene Schichtdickenverlauf 8 durch Gauß-Kurven nachgebildet werden.

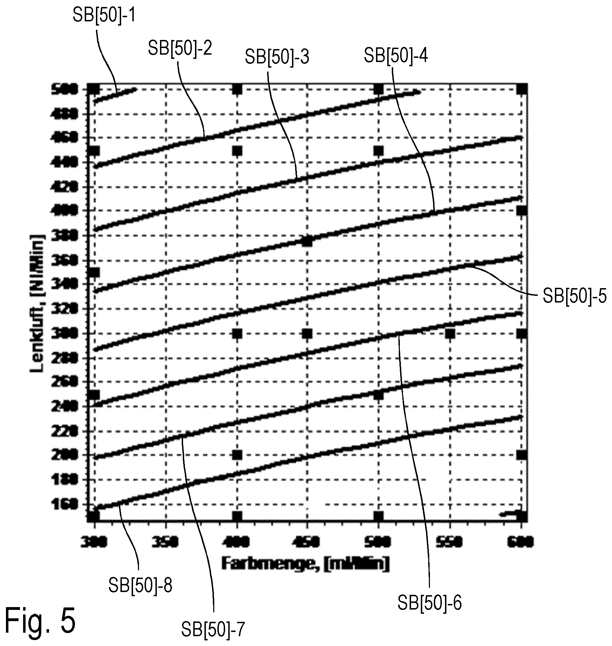

Figur 5 zeigt ein gespeichertes Kennfeld mit Spritzbilddaten für verschiedene Farbmengen und verschiedene Lenkluftströme. Bei den gespeicherten Spritzbilddaten handelt es sich hierbei um verschiedene SB[50]-Werte für die verschiedenen Farbmengen und die verschiedenen Lenkluftströme.

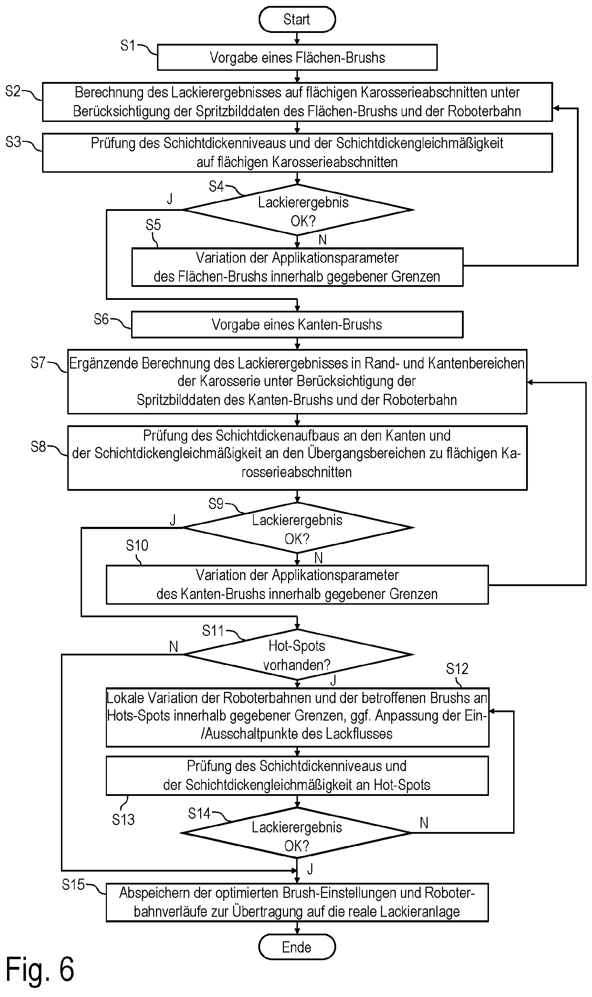

Figur 6 zeigt eine Weiterbildung des erfindungsgemäßen Programmierverfahrens.

In einem ersten Schritt S1 wird zunächst ein Flächen-Brush (Haupt-Brush) vorgegeben. So definiert der Flächen-Brush sämtliche Applikationsparameter und die Roboterbahn für die Lackierung von großen Flächen der Kraftfahrzeugkarosserie, beispielsweise einer Dachfläche.

In einem Schritt S2 wird das Lackierergebnis dann in der vorstehend beschriebenen Weise virtuell ermittelt, wobei die Spritzbilddaten berücksichtigt werden, die aus der Datenbank ausgelesen werden.

In einem Schritt S3 wird dann geprüft, ob das Schichtdickenniveau der Schichtdickengleichmäßigkeit akzeptabel ist.

In einem Schritt S4 wird dann auf dieser Grundlage geprüft, ob das Lackierergebnis akzeptabel ist.

Falls dies nicht der Fall ist, so erfolgt in einem Schritt S5 eine Variation der Applikationsparameter des Flächen-Brushs innerhalb gegebener Grenzen und die vorstehend genannten Schritte S2-S4 werden in einer Iterationsschleife wiederholt, bis ein akzeptables Lackierergebnis für den Flächen-Brush vorliegt.

In den Schritten S6-S10 erfolgt der gleiche Ablauf dann für einen Kanten-Brush, der zur Lackierung von Rändern und Kantenbereichen der Karosserie verwendet wird.

Schließlich erfolgt dann in den Schritten S11-S15 eine entsprechende Prüfung und Optimierung von Applikationsparametern und Roboterbahnen zur Lackierung von Hot-Spots. Dabei handelt es sich um problematische Oberflächenbereiche der Kraftfahrzeugkarosserien, die nur schwer lackiert werden können.

### Bezugszeichenliste:

- 1: Applikator
- 2: Lackierroboter
- 3: Robotersteuerung
- 4: Datenbank
- 5: Optimierungseinheit
- 6: Recheneinheit
- 7: Anzeigeeinheit
- 8: Real gemessener Schichtdickenverlauf
- 9: Mathematisch angenäherter Schichtdickenverlauf

## Patentansprüche

1. Verfahren zur Programmierung eines programmgesteuerten Beschichtungsroboters (2) zur Beschichtung von Bauteilen, insbesondere eines Lackierroboters (2) zur Lackierung von Kraftfahrzeugkarosseriebauteilen, mit den folgenden Schritten:
a) Vorgabe einer Roboterbahn, die von einem Farbauftreffpunkt eines von dem Beschichtungsroboter (2) geführten Applikators (1) im Beschichtungsbetrieb abgefahren werden soll,
b) Vorgabe von Applikationsparametern, die von dem Applikator (1) und dem Beschichtungsroboter (2) im realen Beschichtungsbetrieb bei der Bewegung entlang der Roboterbahn eingehalten werden sollen, wobei der Begriff Applikationsparameter vorzugsweise die Betriebsgrößen des verwendeten Applikators, wie beispielsweise Zerstäuberdrehzahl, Lenkluftstrom, Lenkluftdruck, Hochspannung einer elektrostatischen Beschichtungsmittelaufladung und/oder Lackvolumenstrom umfasst,
c) Virtuelle Ermittlung eines Lackierergebnisses für die vorgegebene Roboterbahn und die vorgegebenen Applikationsparameter,
mit folgenden Schritten zur virtuellen Ermittlung des Lackierergebnisses:
c1) Auslesen von realen Spritzbilddaten aus einer Datenbank (4) in Abhängigkeit von der vorgegebenen Roboterbahn und/oder den vorgegebenen Applikationsparametern, wobei die aus der Datenbank (4) ausgelesenen realen Spritzbilddaten ein Spritzbild wiedergeben, das der Applikator (1) bei einem realen Beschichtungsbetrieb mit den vorgegebenen Applikationsparametern und/oder auf der vorgegebenen Roboterbahn erzeugt, mit folgenden Schritten zur Ermittlung der Spritzbilddaten:
c1a) Durchführung von realen Applikationsversuchen mit verschiedenen Applikationsparametern und verschiedenen Roboterbahnen,
c1b) Messung des Spritzbildes bei den realen Applikationsversuchen und Bestimmung der entsprechenden Spritzbilddaten für die verschiedenen Applikationsparameter und Roboterbahnen, und
c1c) Speicherung der Spritzbilddaten für die verschiedenen Applikationsparameter und Roboterbahnen in der Datenbank (4), und
c2) Ermittlung des Lackierergebnisses unter Berücksichtigung der erzeugten bzw. aus der Datenbank (4) ausgelesenen realen Spritzbilddaten,
wobei
d) die Datenbank ein Kennfeld enthält, in dem die real gemessenen Spritzbilddaten lediglich einzelne Stützstellen bilden, und
e) die restlichen Kennfeldpunkte aus diesen Stützstellen interpoliert werden,
das Verfahren weiter aufweisend folgende Schritte:
Optimierung der Roboterbahn und der Applikationsparameter in Abhängigkeit von dem ermittelten virtuellen Lackierergebnis,
Visualisierung des Lackierergebnisses,
Prüfung des Lackierergebnisses,
wenn das Lackierergebnis akzeptabel ist:
Übernahme der vorgegebenen Roboterbahn und der vorgegebenen Applikationsparameter für die spätere Lackierung.

2. Verfahren nach Anspruch 1, **dadurch gekennzeichnet,**
a) **dass** die Applikationsparameter wahlweise einen Flächen-Brush oder einen Kanten-Brush festlegen,
b) **dass** der Flächen-Brush zur Beschichtung von großen Bauteilflächen dient,
c) **dass** der Kanten-Brush zur Beschichtung von kleinen Bauteilflächen dient, insbesondere zur Beschichtung von folgenden Bauteilflächen einer Kraftfahrzeugkarosserie:
c1) Kotflügel,
c2) A-Säule,
c3) B-Säule,
c4) C-Säule,
c5) Tornadolinie,
c6) Schwellerbereich, und
d) **dass** die Datenbank (4) Spritzbilddaten sowohl für den Flächen-Brush als auch für den Kanten-Brush enthält.

3. Verfahren nach Anspruch 2, **dadurch gekennzeichnet,**
a) **dass** die Datenbank (4) Spritzbilddaten für Variationen des Flächen-Brushs mit variierten Applikationsparametern enthält, insbesondere für Variationen mindestens einer der folgenden Applikationsparameter:
a1) Zerstäuberdrehzahl,
a2) Lenkluftstrom oder Lenkluftdruck,
a3) Hochspannung einer elektrostatischen Beschichtungsmittelaufladung,
a4) Lackvolumenstrom,
a5) Lackiergeschwindigkeit, mit der der der Beschichtungsroboter (2) den Applikator (1) über das Bauteil bewegt, und/oder
b) **dass** die Datenbank (4) Spritzbilddaten für Variationen des Kanten-Brushs mit variierten Applikationsparametern enthält, insbesondere für Variationen mindestens einer der folgenden Applikationsparameter:
b1) Zerstäuberdrehzahl,
b2) Lenkluftstrom oder Lenkluftdruck,
b3) Hochspannung einer elektrostatischen Beschichtungsmittelaufladung,
b4) Lackvolumenstrom,
b5) Lackiergeschwindigkeit, mit der der der Beschichtungsroboter (2) den Applikator (1) über das Bauteil bewegt.

4. Verfahren nach einem der vorhergehenden Ansprüche, **gekennzeichnet durch** folgende Schritte:
a) Ermittlung des Lackierergebnisses für die verschiedenen Variationen des Flächen-Brushs, und
b) Auswahl der Variation des Flächen-Brushs, die zu dem besten Lackierergebnis führt.

5. Verfahren nach einem der vorhergehenden Ansprüche, **gekennzeichnet durch** folgende Schritte:
a) Virtuelle Ermittlung des Lackierergebnisses für die verschiedenen Variationen des Kanten-Brushs, und
b) Auswahl der Variation des Kanten-Brushs, die zu dem besten Lackierergebnis führt.

6. Verfahren nach einem der vorhergehenden Ansprüche, **gekennzeichnet durch** folgende Schritte:
a) Virtuelle Ermittlung des Lackierergebnisses für die verschiedenen Variationen der Roboterbahn, und
b) Auswahl der Variation der Roboterbahn, die zu dem besten Lackierergebnis führt.

7. Verfahren nach einem der vorhergehenden Ansprüche, **dadurch gekennzeichnet, dass** die Spritzbilddaten für die einzelnen Spritzbilder jeweils mindestens einen Spritzbild-Kennwert umfassen, insbesondere einen SB[50]-Wert oder einen SDmax-Wert.

8. Verfahren nach einem der vorhergehenden Ansprüche, **dadurch gekennzeichnet,**
a) **dass** die Spritzbilddaten einen Schichtdickenverlauf wiedergeben, und/oder
b) **dass** der Schichtdickenverlauf durch mathematische Kurven, insbesondere Gauß-Kurven, wiedergegeben wird.

9. Verfahren nach einem der vorhergehenden Ansprüche, **dadurch gekennzeichnet,**
a) **dass** das Lackierergebnis grafisch dargestellt wird mit einer Schichtdickenverteilung, und/oder
b) **dass** das Lackierergebnis berechnet wird unter Berücksichtigung der ausgelesenen Spritzbilddaten und der Applikationsparameter.

10. Verfahren nach einem der vorhergehenden Ansprüche, **dadurch gekennzeichnet, dass** die Applikationsparameter folgende Betriebsgrößen des Applikators (1) und/oder des Beschichtungsroboters (2) bestimmen:
a) Zerstäuberdrehzahl eines Rotationszerstäubers (1), der den Applikator (1) bildet,
b) Lenkluftstrom oder Lenkluftdruck von Lenkluft, die zur Formung eines Sprühstrahls des Applikators (1) abgegeben wird,
c) Hochspannung einer elektrostatischen Beschichtungsmittelaufladung,
d) Lackvolumenstrom, der von dem Applikator (1) abgegeben wird,
e) Antriebsluftstrom oder Antriebsluftdruck zum Antrieb einer Druckluftturbine eines Rotationszerstäubers (1), der den Applikator (1) bildet,
f) Ziehgeschwindigkeit, mit der der Beschichtungsroboter (2) den Applikator (1) über das zu beschichtende Bauteil bewegt, und/oder
g) Applikationsabstand zwischen dem Applikator (1) und dem zu beschichtenden Bauteil.

11. Beschichtungsanlage zur Beschichtung von Bauteilen mit einem Beschichtungsmittel, insbesondere zur Lackierung von Kraftfahrzeugkarosseriebauteilen, mit
a) einem Beschichtungsroboter (2),
b) einem Applikator (1), der von dem Beschichtungsroboter (2) geführt wird und eingerichtet ist, im Betrieb das Beschichtungsmittel auf das Bauteil zu applizieren,
c) einer Datenbank (4), die für verschiedene Applikationsparameter und verschiedene Roboterbahnen Spritzbilddaten enthält, die ein Spritzbild wiedergeben, das der Applikator (1) bei einem realen Beschichtungsbetrieb mit den Applikationsparametern und/oder auf der Roboterbahn erzeugt, und
d) einer Recheneinheit (6), eingerichtet, aus vorgegebenen Applikationsparametern und einer vorgegebenen Roboterbahn virtuell ein Lackierergebnis zu berechnen und dabei die gespeicherten Spritzbilddaten für die vorgegebenen Applikationsparameter und die vorgegebene Roboterbahn zu berücksichtigen, wobei
e) die Datenbank ein Kennfeld enthält, in dem die real gemessenen Spritzbilddaten lediglich einzelne Stützstellen bilden, und
f) die Recheneinheit eingerichtet ist, die restlichen Kennfeldpunkte aus diesen Stützstellen zu interpolieren,
und die Beschichtungsanlage zur Ausführung des Verfahrens nach einem der Ansprüche 1-10 eingerichtet ist.

12. Beschichtungsanlage nach Anspruch 11, **gekennzeichnet durch** eine Anzeigeeinheit (7) zur grafischen Visualisierung des virtuell ermittelten Lackierergebnisses.

## Claims

1. Method for programming a program-controlled coating robot (2) for coating components, in particular a painting robot (2) for painting motor vehicle body components, having the following steps:
a) Specification of a robot path which is to be traversed by a paint impact point of an applicator (1) guided by the coating robot (2) in coating operation,
b) specification of application parameters which are to be maintained by the applicator (1) and the coating robot (2) in real coating operation during movement along the robot path, wherein the term application parameters preferably includes the operating parameters of the applicator used, as for example the atomizer rotary speed, shaping air flow, shaping air pressure, high voltage of an electrostatic coating agent charging system and/or paint volume flow,
c) virtual determination of a coating result for the predetermined robot path and the predetermined application parameters,
with the following steps for the virtual determination of the coating result:
c1) reading out real spray pattern data from a database (4) as a function of the predetermined robot path and/or the predetermined application parameters, the real spray pattern data read out from the database (4) reproducing a spray pattern which the applicator (1) generates during a real coating operation with the predetermined application parameters and/or on the predetermined robot path, with the following steps for the determination of the spray pattern data:
c1a) carrying out real application tests with different application parameters and different robot paths,
c1b) measuring the spray pattern during the real application tests and determining the corresponding spray pattern data for the different application parameters and robot paths, and
c1c) storing the spray pattern data for the various application parameters and robot paths in the database (4), and
c2) determining the coating result taking into account the real spray pattern data generated or read out from the database (4),
wherein
d) the database contains a characteristic map in which the real measured spray pattern data only form individual interpolation points, and
e) the remaining map points are interpolated from these interpolation points,
the method further comprises the following steps:
Optimizing the robot path and the application parameters as a function of the determined virtual coating result,
optimizing the robot path and the application parameters depending on the determined virtual coating result,
visualization of the coating result,
checking the coating result,
if the coating result is acceptable:
adoption of the specified robot path and the specified application parameters for subsequent coating.

2. Method according to claim 1, **characterized in**
a) **that** the application parameters optionally define a surface brush or an edge brush,
b) **that** the surface brush is used for coating large component surfaces,
c) **that** the edge brush is used for coating small component surfaces, in particular for coating the following component surfaces of a motor vehicle body:
c1) Fender,
c2) A-pillar,
c3) B-pillar,
c4) C-pillar,
c5) tornado line,
c6) sill area, and
d) **that** the database (4) contains spray pattern data for both the surface brush and the edge brush.

3. Method according to claim 2, **characterized in**
a) **that** the database (4) contains spray pattern data for variations of the surface spray with varied application parameters, in particular for variations of at least one of the following application parameters:
a1) atomizer rotational speed,
a2) shaping air flow or shaping air pressure,
a3) high voltage of an electrostatic coating agent charging,
a4) paint volume flow,
a5) coating speed at which the coating robot (2) moves the applicator (1) over the component, and/or
b) **that** the database (4) contains spray pattern data for variations of the edge brush with varied application parameters, in particular for variations of at least one of the following application parameters:
b1) atomizer rotational speed,
b2) shaping air flow or shaping air pressure,
b3) high voltage of an electrostatic coating agent charge,
b4) paint volume flow,
b5) coating speed at which the coating robot (2) moves the applicator (1) over the component.

4. Method according to one of the preceding claims,
**characterized by** the following steps:
a) determining the coating result for the different variations of the surface brush; and
b) selecting the variation of the surface brush that leads to the best coating result.

5. Method according to any of the preceding claims,
**characterized by** the following steps:
a) virtual determination of the coating result for the different variations of the edge-brush, and
b) selection of the variation of the edge-brush that leads to the best coating result.

6. Method according to any of the preceding claims,
**characterized by** the following steps:
a) virtually determining the coating result for the different variations of the robotic path; and
b) selecting the variation of the robot trajectory that leads to the best coating result.

7. Method according to one of the preceding claims, **characterized in that** the spray pattern data for the individual spray patterns each comprise at least one spray pattern characteristic value, in particular an SB[50] value or an SDmax-value.

8. Method according to one of the preceding claims, **characterized in**
a) **that** the spray pattern data reproduce a coating thickness profile, and/or
b) **that** the coating thickness profile is represented by mathematical curves, in particular Gaussian curves.

9. Method according to one of the preceding claims, **characterized in**
a) **that** the coating result is represented graphically with a coating thickness distribution, and/or
b) **that** the coating result is calculated taking into account the read-out spray pattern data and the application parameters.

10. Method according to one of the preceding claims, **characterized in that** the application parameters determine the following operating variables of the applicator (1) and/or the coating robot (2):
a) atomizer rotational speed of a rotary atomizer (1) forming the applicator (1),
b) shaping air flow or shaping air pressure of shaping air delivered to form a spray of the applicator (1),
c) high voltage of an electrostatic coating agent charge,
d) coating volume flow delivered by the applicator (1),
e) drive air flow or drive air pressure for driving a compressed air turbine of a rota-tion atomizer (1) forming the applicator (1),
f) drawing speed at which the coating robot (2) moves the applicator (1) over the component to be coated, and/or
g) application distance between the applicator (1) and the component to be coated.

11. Coating installation for coating components with a coating agent, in particular for painting motor vehicle body components, having
a) a coating robot (2),
b) an applicator (1) which is guided by the coating robot (2) and adapted to apply the coating agent to the component during operation,
c) a database (4) which contains spray pattern data for various application parameters and various robot paths, which reproduce a spray pattern which the applicator (1) generates during a real coating operation with the application parameters and/or on the robot path, and
d) a computing unit (6) which is adapted to virtually calculate a coating result from predetermined application parameters and a predetermined robot path and in doing so taking into account the stored spray pattern data for the predetermined application parameters and the predetermined robot path,
wherein
e) the database contains a characteristic map in which the real measured spray pattern data only form individual interpolation points, and
f) the computing unit is adapted to interpolate the remaining map points from these interpolation points,
and the coating system is adapted to carry out the method according to any of claims 1-10.

12. Coating system according to claim 11, **characterized by** a display unit (7) for graphical visualization of the virtually determined coating result.

## Revendications

1. Procédé de programmation d'un robot de revêtement à commande programmée (2) pour le revêtement de pièces, plus particulièrement d'un robot de peinture (2) pour la peinture de pièces de carrosserie de véhicules automobiles, comprenant les étapes suivantes :
a) définition d'une trajectoire de robot qui doit être parcourue en fonctionnement de revêtement par un applicateur (1) guidé par le robot de revêtement (2) au niveau d'un point d'impact de la peinture,
b) définition de paramètres d'application qui doivent être respectés par l'applicateur (1) et le robot de revêtement (2) en fonctionnement de revêtement réel lors du mouvement le long de la trajectoire de robot, dans lequel le terme paramètre d'application comprend de préférence les grandeurs de fonctionnement de l'applicateur utilisé, par exemple la vitesse de rotation du pulvérisateur, le flux d'air de guidage, la pression d'air de guidage, la haute tension d'une charge électrostatique de produit de revêtement et/ou le débit volumique de peinture,
c) détermination virtuelle d'un résultat de peinture pour la trajectoire de robot définie et les paramètres d'application définis, avec les étapes suivantes pour la détermination virtuelle du résultat de peinture :
c1) lecture de données de jet réelles à partir d'une base de données (4) en fonction de la trajectoire de robot définie et/ou des paramètres d'application définis, dans lequel les données de jet réelles lues à partir de la base de données (4) reproduisent un jet que l'applicateur (1) produit lors d'un fonctionnement de revêtement réel avec les paramètres d'application définis et/ou sur la trajectoire de robot définie, avec les étapes suivantes pour la détermination des données de jet :
c1a) réalisation d'essais d'application réels avec différents paramètres d'application et différentes trajectoires de robot,
c1b) mesure du jet lors des essais d'application réels et détermination des données de jet correspondantes pour les différents paramètres d'application et trajectoires de robot, et
c1c) stockage des données de jet pour les différents paramètres d'application et trajectoires de robot dans la base de données (4), et
c2) détermination du résultat de peinture en tenant compte des données de jet réelles produites ou lues à partir de la base de données (4),
d) dans lequel la base de données contient une carte caractéristique dans laquelle les données de jet réellement mesurées ne forment que des points de support isolés, et
e) dans lequel les points restants de la carte caractéristique sont interpolés à partir de ces points de support, le procédé comprenant en outre les étapes suivantes :
optimisation de la trajectoire de robot et des paramètres d'application en fonction du résultat de peinture virtuel déterminé,
visualisation du résultat de peinture,
vérification du résultat de peinture,
si le résultat de peinture est acceptable :
prise en compte de la trajectoire de robot définie et des paramètres d'application définis pour la peinture ultérieure.

2. Procédé selon la revendication 1, **caractérisé en ce que**
a) les paramètres d'application définissent au choix un « Flächen-Brush » (pinceau de surface) ou un « Kanten-Brush » (pinceau de bord),
b) le « Flächen-Brush » permet le revêtement de grandes surfaces de pièces,
c) le « Kanten-Brush » permet le revêtement de petites surfaces de pièces, plus particulièrement le revêtement des surfaces de pièces suivantes d'une carrosserie de véhicule automobile :
c1) aile,
c2) montant A,
c3) montant B,
c4) montant C,
c5) ligne tornade
c6) bas de caisse et
d) la base de données (4) contient des données de jet pour le « Flächen-Brush » ainsi que pour le « Kanten-Brush ».

3. Procédé selon la revendication 2, **caractérisé en ce que**
a) la base de données (4) contient des données de jet pour des variations du « Flächen-Brush" avec des paramètres d'application variés, plus particulièrement pour des variations d'au moins l'un des paramètres d'application suivants :
a1) vitesse de rotation du pulvérisateur,
a2) débit d'air de guidage ou pression d'air de guidage,
a3) haute tension d'une charge électrostatique de produit de revêtement,
a4) débit volumique de peinture,
a5) vitesse de peinture avec laquelle le robot de revêtement (2) déplace l'applicateur (1) au-dessus de la pièce, et/ou
b) la base de données (4) contient des données de jet pour des variations du « Kanten-Brush » avec des paramètres d'application variés, plus particulièrement pour des variations d'au moins l'un des paramètres d'application suivants :
b1) vitesse de rotation du pulvérisateur,
b2) débit d'air de guidage ou pression d'air de guidage,
b3) haute tension d'une charge électrostatique de produit de revêtement,
b4) débit volumique de peinture,
b5) vitesse de peinture avec laquelle le robot de revêtement (2) déplace l'applicateur (1) au-dessus de la pièce.

4. Procédé selon l'une des revendications précédentes, **caractérisé par** les étapes suivantes :
a) détermination du résultat de peinture pour les différentes variations du « Flächen-Brush », et
b) sélection de la variation du « Flächen-Brush » qui conduit au meilleur résultat de peinture.

5. Procédé selon l'une des revendications précédentes, **caractérisé par** les étapes suivantes :
a) détermination virtuelle du résultat de peinture pour les différentes variations du « Kanten-Brush », et
b) sélection de la variation du « Kanten-Brush » qui conduit au meilleur résultat de peinture.

6. Procédé selon l'une des revendications précédentes, **caractérisé par** les étapes suivantes :
a) détermination virtuelle du résultat de peinture pour les différentes variations de la trajectoire de robot, et
b) sélection de la variation de la trajectoire de robot qui conduit au meilleur résultat de peinture.

7. Procédé selon l'une des revendications précédentes, **caractérisé en ce que** les données de jet pour les jets individuels comprennent chacune au moins une valeur caractéristique de jet, plus particulièrement une valeur SB[50] ou une valeur SDmax.

8. Procédé selon l'une des revendications précédentes, **caractérisé en ce que**
a) les données de jet reproduisent une évolution de l'épaisseur de couche, et/ou
b) l'évolution de l'épaisseur de couche est représentée par des courbes mathématiques, en particulier des courbes de Gauss.

9. Procédé selon l'une des revendications précédentes, **caractérisé en ce que**
a) le résultat de peinture est représenté graphiquement avec une distribution d'épaisseur de couche, et/ou
b) le résultat de peinture est calculé en tenant compte des données de jet lues et des paramètres d'application.

10. Procédé selon l'une des revendications précédentes, **caractérisé en ce que** les paramètres d'application déterminent les grandeurs de fonctionnement suivantes de l'applicateur (1) et/ou du robot de revêtement (2) :
a) vitesse de rotation d'un pulvérisateur rotatif (1) qui forme l'applicateur (1),
b) flux d'air de guidage ou pression d'air de guidage de l'air de guidage qui est délivré pour former un jet de pulvérisation de l'applicateur (1),
c) haute tension d'une charge électrostatique de produit de revêtement,
d) débit volumique de peinture qui est délivré par l'applicateur (1),
e) flux d'air d'entraînement ou pression d'air d'entraînement pour l'entraînement d'une turbine à air comprimé d'un pulvérisateur rotatif (1) qui forme l'applicateur (1),
f) vitesse de déplacement avec laquelle le robot de revêtement (2) déplace l'applicateur (1) au-dessus de la pièce à revêtir, et/ou
g) distance d'application entre l'applicateur (1) et la pièce à revêtir.

11. Installation de revêtement pour le revêtement de pièces avec un produit de revêtement, plus particulièrement pour la peinture de pièces de carrosserie de véhicules automobiles, avec
a) un robot de revêtement (2),
b) un applicateur (1) qui est guidé par le robot de revêtement (2) et qui est conçu pour appliquer en fonctionnement le produit de revêtement sur la pièce,
c) une base de données (4) qui contient pour différents paramètres d'application et différentes trajectoires de robot des données de jet qui reproduisent un jet que l'applicateur (1) produit lors d'un fonctionnement de revêtement réel avec les paramètres d'application et/ou sur la trajectoire de robot, et
d) une unité de calcul (6) qui est conçue pour calculer virtuellement un résultat de peinture à partir de paramètres d'application définis et d'une trajectoire de robot définie et pour tenir compte des données de jet stockées pour les paramètres d'application définis et la trajectoire de robot définie,
e) dans laquelle la base de données contient une carte caractéristique dans laquelle les données de jet réellement mesurées ne forment que des points de support isolés, et
f) dans laquelle l'unité de calcul (6) est conçue pour interpoler les points restants de la carte caractéristique à partir de ces points de support, et l'installation de revêtement est conçue pour exécuter le procédé selon l'une des revendications 1 à 10.

12. Installation de revêtement selon la revendication 11, **caractérisée par** une unité d'affichage (7) pour la visualisation graphique du résultat de peinture déterminé virtuellement.
